(19) Europäisches Patentamt
European Patent Office
Office européen des brevets

(11) **EP 1 291 878 B1**

(12) **EUROPÄISCHE PATENTSCHRIFT**

(45) Veröffentlichungstag und Bekanntmachung des Hinweises auf die Patenterteilung:
**17.04.2013 Patentblatt 2013/16**

(51) Int Cl.:
***G11C 7/10*** *(2006.01)*  ***G06F 12/06*** *(2006.01)*

(21) Anmeldenummer: **02102326.2**

(22) Anmeldetag: **06.09.2002**

(54) **Steuereinrichtung zur Steuerung von Burst-Zugriffen**

Control device for control of burst access

Dispositif de commande pour commander un accès en rafale

(84) Benannte Vertragsstaaten:
**AT BE BG CH CY CZ DE DK EE ES FI FR GB GR IE IT LI LU MC NL PT SE SK TR**

(30) Priorität: **11.10.2001 DE 10150125**
**07.09.2001 DE 10143999**

(43) Veröffentlichungstag der Anmeldung:
**12.03.2003 Patentblatt 2003/11**

(73) Patentinhaber:
• **Philips Intellectual Property & Standards GmbH 20099 Hamburg (DE)**
Benannte Vertragsstaaten:
**DE**
• **NXP B.V.**
**5656 AG Eindhoven (NL)**

(72) Erfinder: **Nicolai, Volker**
**52088, Aachen (DE)**

(74) Vertreter: **Small, Gary James et al**
**Carpmaels & Ransford**
**One Southampton Row**
**London WC1B 5HA (GB)**

(56) Entgegenhaltungen:
**US-A- 5 634 034  US-A- 5 636 173**
**US-A- 5 710 904**

**Beschreibung**

Die Erfindung betrifft eine Steuereinrichtung zur Steuerung von Burst-Zugriffen auf eine synchrone dynamische, wenigstens zwei Speicherbänke aufweisende Halbleiterspeichervorrichtung. Ausserdem betrifft die Erfindung ein Verfahren zur Steuerung von Burst-Zugriffen.

Synchrone dynamische Halbleiterspeichervorrichtungen (SDRAMs), wie sie vielfach bekannt und in Benutzung sind, haben den Nachteil, dass relativ grosse Zeitverluste bei statistisch verteilten Zugriffen durch sogenannte Vorbereitungszyklen, Vorladen (precharge) und Aktivieren (activate), entstehen. Insbesondere bei wahlfreien Burst-Zugriffen, d. h. bei Lese- oder Schreibzugriffen auf den Speicher, bei denen mit einem Befehl mehrere Datenworte ausgelesen oder eingeschrieben werden sollen, die im Speicher nebeneinander liegen, kann dies sehr störend sein, da gerade derartige Burst-Zugriffe einen schnellen Datenzugriff ermöglichen sollen.

Die meisten zur Zeit auf dem Markt befindlichen und dem JEDEC-Standard genügenden SDRAMs sind so konstruiert, dass sie intern aus mehreren separat ansteuerbaren Speichereinheiten mit entsprechender Ansteuerlogik, den sogenannten Speicherbänken, bestehen. US5636173 hat eine Beschreibung einer Synchroner dynamischer Halbleiterspeichervorrichtung (SDRAM) die umfasst zwei unabhängige Speicherbänken. Diese Speicherbänke sind über Multiplexer bzw. Decoder mit den Datenein- und Datenausgängen verbunden und können teilweise zeitlich überlappend angesteuert werden, wobei die eine Speicherbank auf den nächsten Zugriff vorbereitet werden kann, während auf eine andere Speicherbank ein Datenzugriff, d. h. ein Lese- oder Schreibzugriff, ausgeführt wird.

Da zwischen den Vorbereitungszyklen (precharge und activate) und dem eigentlichen Datenzugriff oft etliche Zyklen vergehen, in denen der Datenbus blockiert ist, sind bei derartigen Zugriffen Zeitverluste hinzunehmen. Der Erfindung liegt deshalb die Aufgabe zugrunde, eine Steuereinrichtung und ein Verfahren zur Steuerung und Readressierung von Burst-Zugriffen auf eine synchrone dynamische, wenigstens zwei Speicherbänke aufweisende Halbleiterspeichervorrichtung anzugeben, mit denen diese Zeitverluste weitgehend verringert oder gar gänzlich vermieden werden können.

Diese Aufgabe wird erfindungsgemäss durch eine Steuereinrichtung gemäss Anspruch 1 gelöst, welche eine Adresswandlereinheit aufweist zur Umwandlung einer logischen Zugriffsadresse in physikalische Zugriffsadressen durch Aufspaltung des Burst-Zugriffs in wenigstens zwei Teil-Burst-Zugriffe, wobei eine erste physikalische Zugriffsadresse einen ersten Speicherbereich einer ersten Speicherbank für einen ersten Teil-Burst-Zugriff adressiert und wobei eine zweite physikalische Zugriffsadresse einen zweiten Speicherbereich einer zweiten Speicherbank für einen zweiten Teil-Burst-Zugriff adressiert. Der erste Teil-Burst-Zugriff und der zweite Teil-Burst-Zugriff werden nacheinander ausgeführt, und der zweite Teil-Burst-Zugriff wird während der Durchführung des ersten Teil-Burst-Zugriff vorbereitet. Die genannte Aufgabe wird ausserdem gelöst durch ein Verfahren gemäss Anspruch 7.

Der Erfindung liegt dabei die Erkenntnis zugrunde, dass es vorteilhaft ist, bei jedem Burst-Zugriff die Speicherbank, auf die zugegriffen wird, umzuschalten, unabhängig davon, ob ein Seitenwechsel (page- oder row-Wechsel) erfolgt oder nicht. Dazu wird erfindungsgemäss eine Readressierung vollzogen, die sicher stellt, dass die Speicherbank zwischen zwei aufeinander folgenden Zugriffen umgeschaltet wird und die einen entstehenden virtuellen (logischen) Adressraum vollständig auf einen entsprechend grossen, real vorhandenen (physikalischen) Adressraum abbildet, möglichst ohne dass Fehlstellen oder Doppelbelegungen entstehen.

Erfindungsgemäss wird also ein Burst-Zugriff auf eine bestimmte logische Zugriffsadresse des Speicherbereichs umgewandelt in zwei Teil-Burst-Zugriffe, wobei jeder der beiden Teil-Burst-Zugriffe auf eine andere Speicherbank und darin jeweils einen bestimmten Speicherbereich adressiert. Damit kann sicher gestellt werden, dass keine oder nur minimale Verzögerungen durch Vorbereitungszyklen entstehen. Während nämlich der erste Teil-Burst-Zugriff bereits durchgeführt wird, also bereits auf die erste Speicherbank geschrieben bzw. von der ersten Speicherbank gelesen wird, kann gleichzeitig die Vorbereitung des zweiten Teil-Burst-Zugriffs erfolgen.

Vorteilhafte Ausgestaltungen der erfindungsgemässen Steuereinrichtung sind in den Unteransprüchen angegeben. Durch die vorteilhafte Ausgestaltung gemäss Anspruch 2, wonach die Spaltenadressen der ersten und zweiten physikalischen Zugriffsadressen aneinander anschließen, kann auf einfache Weise erreicht werden, dass der physikalische Adressraum, d. h. der in der Halbleiterspeichervorrichtung vorhandene Speicherbereich, vollständig belegt wird, ohne dass Fehlstellen oder Doppelbelegen entstehen. Der logische Adressraum der logischen Zugriffsadressen kann somit auf einfache Weise auf einen entsprechend großen physikalischen Adressraum vollständig abgebildet werden.

Eine möglichst große Zeitersparnis kann insbesondere dadurch erreicht werden, dass - wie bereits erwähnt und wie in Anspruch 3 angegeben - während eines ersten Teil-Burst-Zugriffs ein zweiter Teil-Burst-Zugriff bereits vorbereitet wird. Wenn der erste Teil-Burst-Zugriff beendet ist, kann somit unmittelbar der zweite Teil-Burst-Zugriff ausgeführt werden, d. h. gelesen oder geschrieben werden, ohne dass eine Verzögerung durch Vorbereitungszyklen entsteht.

Bei der in Anspruch 4 angegebenen Ausgestaltung ist eine sogenannte Kreuzadressierung möglich, d. h., ein erster Burst wird aufgeteilt in einen ersten und zweiten Teil-Burst-Zugriff auf einen ersten und zweiten Speicherbereich der ersten bzw. zweiten Speicherbank, und ein zweiter Burst-Zugriff wird aufgeteilt in einen ersten und zweiten Teil-Burst-Zugriff jeweils auf die selben zwei Speicherbänke, wobei jedoch an andere Speicherbereiche adressiert werden. Vorzugsweise erfolgt die Adressierung so, dass die Speicherbereiche in der ersten und zweiten Speicherbank aneinander anschließen, um die einfache und vollständige Ausfüllung des physikalischen Speicherbereichs zu erreichen.

Bei der vorteilhaften Ausgestaltung gemäß Anspruch 5 wird vorzugsweise auf Speicherbereiche der gleichen Adresse in unterschiedlichen Speicherbänken zugegriffen. Bevorzugt erfolgt bei dieser Ausgestaltung eine Kompression des physikalischen Adressraumes, d. h., physikalische Adressen weisen eine größere Bitzahl, vorzugsweise ein Bit mehr, auf als logische Adressen. So können beispielsweise M Speicherbänke des physikalischen Adressraumes auf N/2 Speicherbänke im logischen Adressraum abgebildet werden, indem bei der logischen Adressierung ein Bit, nämlich beispielsweise ein die Speicherbank des physikalischen Adressraumes bestimmendes Bit, ausgelassen wird.

Vorzugsweise sollte bei dem erfindungsgemäßen Verfahren bzw. der erfindungsgemäßen Steuereinheit für Lese- und Schreibzugriffe immer ein Burst mit der gleichen geraden Anzahl von Worten vorgenommen werden. Es sollte ein dedizierter bzw. exklusiver Speicherbereich für die Zugriffe vorgesehen sein, der nur mit dieser Art von Bursts verwendet wird, da ansonsten die Daten des Speichers irrtümlicherweise überschrieben werden könnten.

Das erfindungsgemäße Verfahren ist insbesondere sinnvoll beim Transfer großer Datenmengen und bei Hardware-Architekturen, die ohne Zwischenspeicher (cache) auskommen müssen, d. h., bei denen ein Umsortieren der Daten vor dem Speicherzugriff nicht möglich oder sinnvoll ist. Vorteile ergeben insbesondere bei nah aufeinander folgenden Zugriffen, d. h. bei zeitkritischem Datendurchsatz auf verschiedene Bereiche innerhalb des dedizierten Speichers und beim häufigen Seitenwechsel (Wechsel der row bzw. der page) sowie bei Bursts der Größe 4 an aufwärts.

Die erfindungsgemäße Steueranordnung mit der Halbleiterspeichervorrichtung kann besonders vorteilhaft für Video-Anwendungen eingesetzt werden, bei denen der Geschwindigkeitsvorteil, den die Anordnung bietet, besonders wichtig ist, da ein Video-Daten-Strom auf keinen Fall abreißen darf, da es sonst sofort zu Bildstörungen kommt.

Die Erfindung wird nachfolgend anhand der Zeichnungen näher erläutert. Es zeigen:

Figur 1    ein Blockschaltbild mit einer Steuereinrichtung für eine Halbleiterspeichervorrichtung,

Figur 2    Signalverläufe bei einem bekannten wahlfreien sequentiellen Verfahren,

Figur 3    ein Blockschaltbild einer erfindungsgemäßen Steuereinrichtung,

Figur 4    ein Diagramm zur Erläuterung der erfindungsgemäßen Kreuzadressierung,

Figur 5    ein Diagramm zur Erläuterung der erfindungsgemäßen Kompression des Adressraumes,

Figur 6    die Adresszuordnung von logischem und physikalischem Adressraum, und

Figur 7    Signalverläufe bei dem erfindungsgemäßen Verfahren.

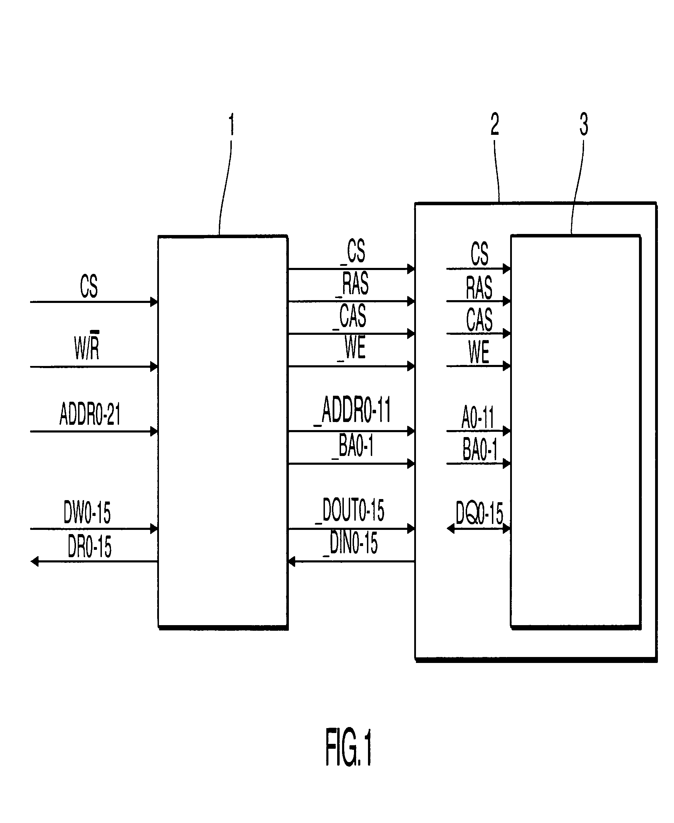

Figur 1 zeigt ein prinzipielles Blockschaltbild einer Ansteuerung eines synchronen dynamischen Halbleiterspeichers (SDRAM). Im allgemeinen ist eine Steuereinrichtung 1 vorgesehen, die als Eingangssignale folgende Signale erhält: Chip-Auswahlsignal (chip select) CS, Schreib-Lese-Auswahlsignal (write-read) $W/\overline{R}$, Adresssignal über einen Adressbus ADDR0-21 mit (im vorliegenden Beispiel) 22 Bit Breite. Über einen Datenschreibbus DW0-15 mit (im vorliegenden Beispiel) 16 Bit Breite können Daten eingeschrieben werden, über einen Datenlesebus DR0-15 mit (im vorliegenden Beispiel) 16 Bit Breite können gelesene Daten ausgegeben werden.

Als Ausgangssignale erzeugt die Steuereinrichtung 1 die folgenden Signale: Chip-Auswahlsignal CS, Reihen-Aktivierungs-Signal (row address strobe) RAS, Spalten-Aktivierungs-Signal (column adress strobe) CAS, Schreibsignal (write enable) WE, Adresssignal über einen Adressbus ADDR0-11 mit (im vorliegenden Beispiel) 12 Bit Breite und Speicherbankauswahlsignal (bank) BA0-1. Über einen Datenschreibbus DOUT0-15 mit (im vorliegenden Beispiel) 16 Bit Breite können Daten zum Schreiben ausgegeben werden, während über einen Datenlesebus DIN0-15 mit (im vorliegenden Beispiel) 16 Bit Breite Daten eingelesen werden können.

Die von der Steuereinrichtung 1 ausgegebenen Signale werden einer Speichereinheit (shell) 2 zugeleitet, die die eigentliche Halbleiterspeichervorrichtung (SDRAM) 3 umgibt. Diese setzt im wesentlichen den Datenschreibbus DOUT0-15 und den Datenlesebus DIN0-15 auf einen gemeinsamen Datenbus DQ0-15 um. Ggf. kann auch eine weitere Testlogik in die Speichereinheit 2 integriert sein.

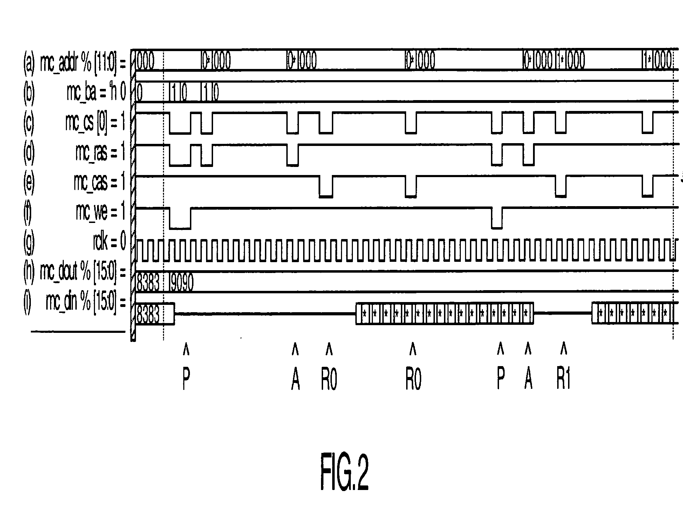

Typische Signalverläufe bei einem Zugriff auf ein bekanntes SDRAM 3 mit einer bekannten Steuereinrichtung sind in Figur 2 gezeigt. Figur 2a zeigt die Adresse, auf die jeweils zugegriffen werden soll, wobei "*" als Platzhalter für nicht darstellbare Bestandteile der Adresse fungiert. Figur 2b zeigt das Speicherbankauswahlsignal BA, wobei 0 bzw. 1 die Nummer der ausgewählten Speicherbank bezeichnet. Figur 2c zeigt das Chip-Auswahlsignal CS, Figur 2d zeigt das Zeilenadresssignal RAS, Figur 2e zeigt das Spaltenadresssignal CAS und Figur 2f zeigt das Schreibsignal WE. Die in den Figuren 2c bis 2f gezeigten Signale bilden dabei den eigentlichen Befehl, mit dem ein Zugriff auf den Speicher vorbereitet und eingeleitet wird. In welcher Weise diese Signale geschaltet werden müssen, um einzelne Befehle auszuführen, ist in dem Standard für Halbleiterspeichervorrichtungen definiert, nämlich dem JEDEC-Standard, und soll hier nicht weiter erläutert werden. Figur 2g zeigt ein Taktsignal RCLK. Figur 2h zeigt den Datenschreibbus DOUT, wobei konkrete Daten gezeigt sind. Figur 2i zeigt den Datenlesebus DIN, wobei ebenfalls Daten gezeigt sind.

In den Signalverläufen ist zunächst die Umschaltung von Schreibbetrieb auf Lesebetrieb (ganz links in den Signalverläufen) gezeigt. Sodann werden zwei Lese-Burst-Zugriffe (R0) der Länge 8 auf die gleiche Seite (bzw. Zeile) auf verschiedenen Spalten und, daran anschließend, ein Lese-Burst-Zugriff (R1) auf eine neue Seite (bzw. Zeile) durchgeführt. Um den ersten Lese-Burst-Zugriff R0 auf die Speicherbank 0 durchführen zu können, muß die Speicherbank 0 zunächst vorgeladen (precharge, P) und aktiviert (activate, A) werden. Dieselbe Vorbereitung ist erforderlich, bevor auf derselben Speicherbank der zweite Lese-Burst-Zugriff R1 auf eine neue Zeile erfolgen kann.

Wie gut zu erkennen ist, vergehen zwischen den Vorbereitungsbefehlen P und A sowie zwischen dem zweiten Vorbereitungsbefehl A und dem eigentlichen Lese-Zugriff R0 bzw. R1 etliche Taktzyklen, in denen der Datenbus blockiert ist, was jedoch auf dem Datenbus mit einigen Taktzyklen Verzögerung zu erkennen ist. Diese Verzögerungen durch die Vorbereitungszyklen führen zu störenden Zeitverlusten bei Burst-Zugriffen, die erfindungsgemäß möglichst stark verringert bzw. vermieden werden können.

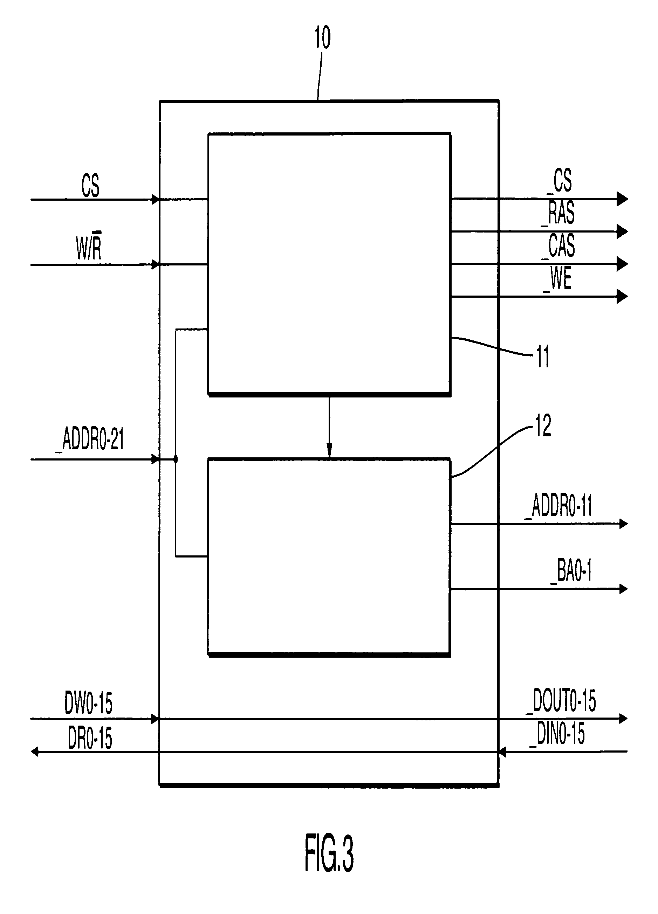

Eine erfindungsgemäße Steuereinrichtung 10 ist in Figur 3 gezeigt. Eingangs- und Ausgangssignale sind identisch mit den in Figur 1 beschriebenen Eingangs- und Ausgangssignalen der Steuereinrichtung 1, so dass eine Kompatibilität mit allen synchronen dynamischen Halbleiterspeichereinrichtungen gegebenen ist. Die Datenleitungen DW0-15 und DR0-15 werden dabei vom Eingang auf den Ausgang "durchgeschleift".

Die Steuerung und Erzeugung der Steuersignale des SDRAMs und damit die Funktion der Aufteilung eines Burst-Zugriffs auf wenigstens zwei Teil-Burst-Zugriffe übernimmt eine sogenannte Zustandsmaschine 11 (Finite State Machine). Diese erkennt, ob ein Burst-Zugriff erwünscht ist, wandelt die Eingangssignale in entsprechende Steuersignale für das SDRAM um und gibt ggf. an eine Adresswandlereinheit 12 den Befehl weiter, den Burst-Zugriff in Teil-Burst-Zugriffe aufzuteilen bzw. die Umwandlung der logischen Zugriffsadresse für den Burst-Zugriff in physikalische Zugriffsadressen für die Teil-Burst-Zugriffe vorzunehmen. Die Zustandsmaschine 11 signalisiert dabei der Adresswandlereinheit 12 auch, wann welche Adresse zu erzeugen ist.

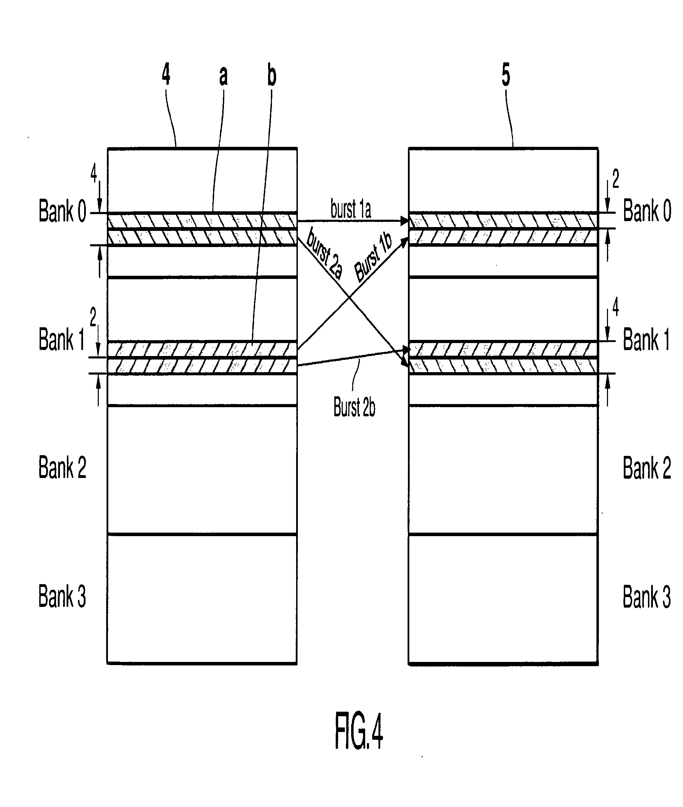

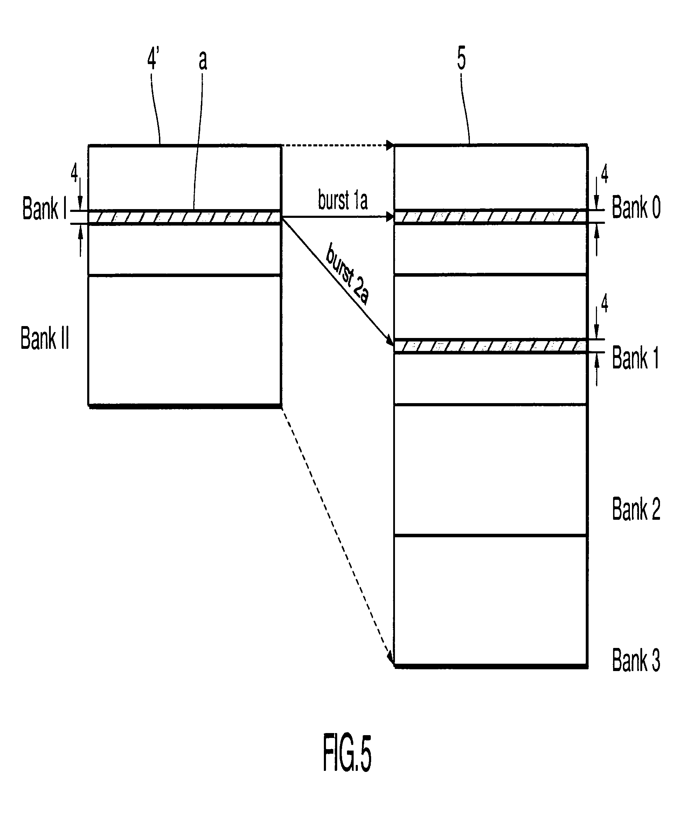

Die Adresswandlereinheit 12 wandelt die über den Eingangs-Adressbus ADDR0-21 eingehenden logischen Zugriffsadressen in physikalische Zugriffsadressen und ein Speicherbanksignal BA0-1 um, wobei die physikalischen Zugriffsadressen über den Ausgangs-Adressbus ADDR0-11 an das SDRAM weitergegeben werden. Die erfindungsgemäße Umwandlung der logischen Zugriffsadressen in physikalische Zugriffsadressen soll nun anhand der Figuren 4 und 5 näher erläutert werden.

Figur 4 zeigt eine erste Möglichkeit einer erfindungsgemäßen Adressumwandlung, nämlich die sogenannte Kreuzadressierung. Darin ist ein logischer Adressraum 4, der auch als originaler oder virtueller Adressraum bezeichnet wird, mit vorliegend vier Speicherbänken (Bank 0 bis Bank 3) gezeigt. Dieser logischer Adressraum 4 wird durch logische Zugriffsadressen adressiert, die der Speichereinrichtung 10 zugeleitet werden, wenn beispielsweise im Rahmen eines Burst-Zugriffes auf einen Speicherbereich des SDRAM zugegriffen werden soll.

Weiter ist in Figur 4 ein physikalischer Adressraum 5, der auch als realer Adressraum bezeichnet wird, gezeigt. Dieser physikalischer Adressraums weist ebenfalls vier Speicherbänke (Bank 0 bis Bank 3) auf, was jedoch nicht zwingend der Fall sein muß. Einzelne Speicherzellen des SDRAM werden in diesem physikalischen Adressraum 5 durch physikalische Zugriffsadressen explizit adressiert. Die Umwandlung der logischen Zugriffsadressen des logischen Adressraumes 4 in physikalische Zugriffsadressen des physikalischen Adressraumes 5 erfolgt erfindungsgemäß durch die Adresswandlereinheit 12.

In dem in Figur 4 gezeigten Beispiel sollen zwei Burst-Zugriffe a und b jeweils der Länge vier nacheinander erfolgen. Erfindungsgemäß wird zunächst der erste Burst-Zugriff a, der einen logischen Adressbereich der Speicherbank 0 des logischen Adressraumes 4 adressiert, in zwei Teil-Burst-Zugriffe 1a und 2a jeweils der Länge zwei aufgespalten. Der erste Teil-Burst-Zugriff 1a adressiert dabei einen ersten Speicherbereich der ersten Speicherbank 0, während der zweite Teil-Burst-Zugriff 2a einen zweiten Speicherbereich der zweiten Speicherbank 1 adressiert. Zur Ausführung des Burst-Zugriffes a werden somit nacheinander die Teil-Burst-Zugriffe 1a und 2a ausgeführt, d. h., es wird nacheinander auf die Adressbereiche der Speicherbank 0 und der Speicherbank 1 des physikalischen Speichers zugegriffen. Der Vorteil liegt dabei darin, dass während der Durchführung des ersten Teil-Burst-Zugriffes 1a bereits der zweite Teil-Burst-Zugriff 2a vorbereitet werden kann, da dabei ja auf eine andere Speicherbank zugegriffen wird. Eine Wartezeit durch Vorbereitungszyklen entfällt somit.

Wenn nun ein zweiter Burst-Zugriff b auf den logischen Adressbereich entsprechend Zugriff a, aber in Speicherbank 1 des logischen Adressraumes 4 erfolgen soll, wird dieser Burst-Zugriff b wiederum aufgespalten in zwei Teil-Burst-Zugriffe 1b und 2b. Die Adressumwandlung erfolgt dabei derart, dass der erste Teil-Burst-Zugriff 1b auf einen zweiten Speicherbereich der Speicherbank 0 des physikalischen Adressraumes 5 zugreift, während der zweite Teil-Burst-Zugriff 2b einen Speicherbereich der Speicherbank 1 des physikalischen Adressraumes 5 adressiert. Die Adressierung erfolgt dabei vorzugsweise derart, dass die Daten der Teil-Burst-Zugriffe 1a und 1b bzw. 2a und 2b jeweils aneinander anschließen, so dass in beiden Speicherbänken 0 und 1 des physikalischen Adressraumes 5 die gleichen Speicherbereiche beschrieben bzw. ausgelesen sind, nachdem beide Burst-Zugriffe a und b ausgeführt wurden.

Allgemein ausgedrückt erfolgt die erfindungsgemäße Adressumwandlung einer logischen Zugriffsadresse A einer Speicherbank X bei einem Burst-Zugriff der Länge N derart, dass ein erster Teil-Burst-Zugriff der Länge N/2 auf eine erste physikalische Zugriffsadresse B einer ersten Speicherbank Y und einen zweiten Teil-Burst-Zugriff der Länge N/2 auf eine zweite physikalische Zugriffsadresse C einer zweiten Speicherbank Y+Z erfolgt, wobei Z eine ganze Zahl ungleich 0 ist, vorzugsweise +1, wenn Y eine gerade ganze Zahl ist, oder -1, wenn Y eine ungerade ganze Zahl ist. Vorzugsweise entspricht die erste Speicherbank Y der physikalischen Adressierung dabei der Speicherbank X der logischen Adressierung; die erste physikalische Zugriffsadresse B der physikalischen Adressierung entspricht vorzugsweise der logischen Zugriffsadresse A der logischen Adressierung und die zweite physikalische Zugriffsadresse C entspricht vorzugsweise der logischen Zugriffsadresse A+N/2.

In Figur 5 ist eine zweite erfindungsgemäße Möglichkeit zur Umwandlung logischer Zugriffsadressen in physikalische Zugriffsadressen gezeigt. Darin sind wieder ein logischer Adressraum 4' sowie ein physikalischer Adressraum 5 gezeigt, wobei der logische Adressraum 4' jedoch gegenüber dem physikalischen Adressraum 5 sowie gegenüber dem in Figur 4 gezeigten logischen Adressraum 4 komprimiert ist, im Beispiel um den Faktor 2. Es werden somit aus N Speicherbänken des physikalischen Adressraumes N/2 Speicherbänke im logischen Adressraum 4' bzw. aus A physikalischen Zugriffsadressen werden A/2 logische Zugriffsadressen bei einer Reduktion des Adressraumes um den Faktor 2. Dies entspricht dem Weglassen eines Bits bei der Adressierung im logischen Adressraum 4' gegenüber der Adressierung im physikalischen Adressraum 5.

Ein Burst-Zugriff a, bei dem im logischen Adressraum 4' eine logische Zugriffsadresse A einer Speicherbank I adressiert wird, wird bei dieser Ausgestaltung des erfindungsgemäßen Verfahrens auf zwei (oder mehr) Teil-Burst-Zugriffe 1a und 2a aufgespalten, die jeweils eine unterschiedliche Speicherbank, aber vorzugsweise die identische physikalische Zugriffsadresse des physikalischen Adressraumes 5 adressieren. Im allgemeinen wird also mit dem Teil-Burst-Zugriff 1a eine physikalische Zugriffsadresse B einer ersten Speicherbank Y, und mit dem zweiten Teil-Burst-Zugriff 2a eine zweite physikalische Zugriffsadresse B einer zweiten Speicherbank Y+Z adressiert, wobei Z eine ganze Zahl ungleich 0 ist und wobei vorzugsweise A = B ist. Die Teil-Burst-Zugriffe 1a und 2a werden dabei wiederum nacheinander ausgeführt, wobei während der Durchführung des ersten Teil-Burst-Zugriffes 1a der zweite Teil-Burst-Zugriff 2a vorbereitet wird, um unnötige Wartezeiten für Vorbereitungsbefehle zu vermeiden.

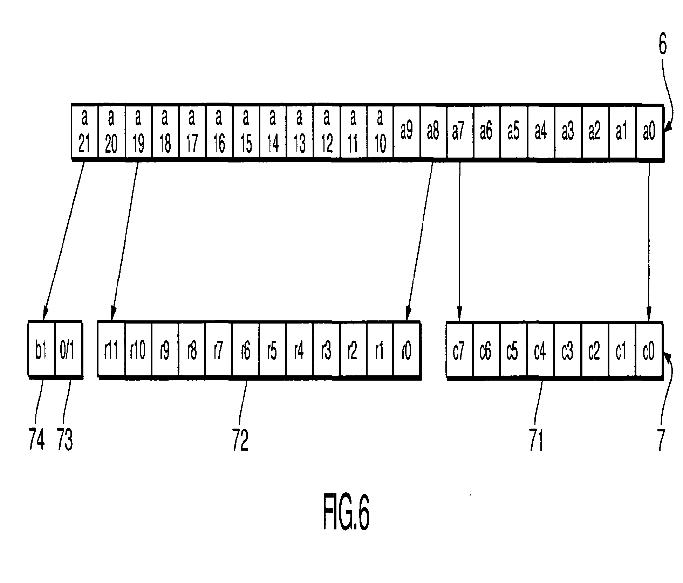

Die erfindungsgemäße Umwandlung der logischen Zugriffsadressen in physikalische Zugriffsadressen erfolgt bei dem in Figur 5 beschriebenen Verfahren durch Hinzufügen eines Bits; anders ausgedrückt, die logischen Zugriffsadressen entstehen aus den physikalischen Zugriffsadressen durch Weglassen eines Bits, insbesondere des die Speicherbänke im physikalischen Adressraum 5 kennzeichnenden Speicherbank-Bits. Dies ist in Figur 6 gezeigt. Dort ist eine logische Zugriffsadresse 6, bestehend aus 22 Adressbits a0-a21 gezeigt, die über den Adressbus der Steuereinrichtung bei einem Burst-Zugriff zugeführt wird. Darunter ist die in der erfindungsgemäßen Steuereinrichtung, insbesondere der Adresswandlereinheit erzeugte physikalische Adresse 7 gezeigt, die aus mehreren Bestandteilen 71 bis 74 besteht.

Erfindungsgemäß werden die untersten acht Bits a0 bis a7 der logischen Zugriffsadresse 6 auf die Spaltenadresse 71 mit den Spaltenadressenbits c0 bis c7 abgebildet, und die nächsten 12 Bits a8 bis a18 der logischen Zugriffsadresse 6 werden auf die Zeilenadresse 72 mit den Zeilenadressbits r0 bis r11 umgesetzt. Die obersten zwei Adressbits a20 und a21 entsprechen den Speicherbankbits 73, 74 des SDRAM, wobei das oberste Adressbit a21 auf das obere Bankbit 74 (b1) abgebildet wird, während das untere Adressbit a20 ausmaskiert wird. Das Speicherbankbit 73 wird erfindungsgemäß erst in der Adresswandlereinrichtung erzeugt bzw. hinzugefügt, d. h. es wird getoggled durch Setzen auf 0 für den ersten Teil-Burst-Zugriff und auf 1 für den zweiten Teil-Burst-Zugriff. Effektiv stehen somit im logischen Adressraum nur 21 und nicht 22 Adressbits zur Verfügung, was der beschriebenen Kompression um den Faktor 2 entspricht.

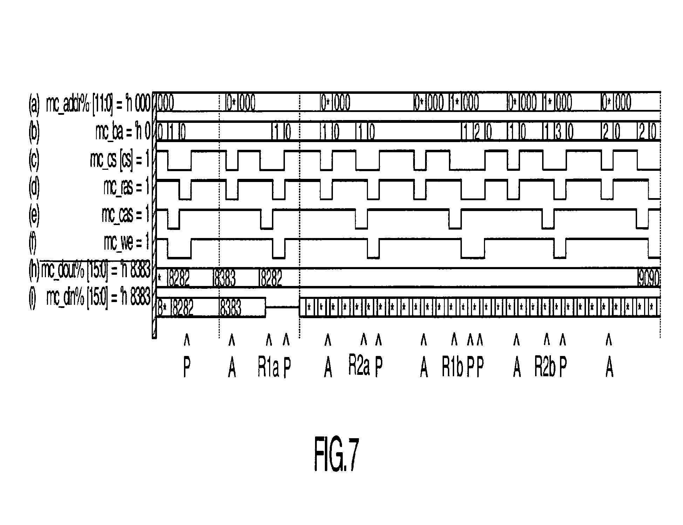

Signalverläufe bei einer erfindungsgemäßen Steuereinrichtung sind in Figur 7 gezeigt für den Fall der in den Figuren 5 und 6 beschriebenen Adresskompression. Darin sind vier Lesezugriffe R1a, R2a, R1b, R2b gezeigt, wobei in den Lesezugriffen R1a und R1b auf die Speicherbank 0 (siehe Speicherbank-Signal in Figur 7b) und in den Lesezugriffen R2a und R2b auf die Speicherbank1 zugegriffen wird. Wie zu erkennen ist, wird zunächst die Speicherbank 0 vorbereitet durch precharge P und activate A, bevor der erste Lesezugriff R1a auf die Speicherbank 0 erfolgt. Sodann wird jedoch nicht, wie bei dem Signalverlauf in Figur 2, mit der Vorbereitung der Speicherbank 1 gewartet, bis der erste Lesezugriff R1a vollständig durchgeführt ist, sondern es wird unmittelbar dem Lesebefehl R1a die Speicherbank 1 durch precharge P und activate A vorbereitet, auf die dann auch unmittelbar der zweite Lesezugriff R2a erfolgt, sobald der erste Lesezugriff R1a beendet ist. Danach wird erneut sofort wieder die Speicherbank 0 vorbereitet, und der dritte Lesezugriff R1b auf die Speicherbank 0 erfolgt, sobald der zweite Lesezugriff R2a beendet ist. Danach erfolgt wiederum die Vorbereitung der Speicherbank 1, bevor der vierte Lesezugriff R2b darauf erfolgt.

Gleichzeitig sind auch noch die ersten Vorbereitungsschritte der Vorbereitungshandlungen für einen Zugriff auf die Speicherbänke 2 und 3 gezeigt, die auch gleichzeitig zur Vorbereitung bzw. gleichzeitig zu Lesezugriffen auf die Speicherbänke 0 und 1 erfolgen können. Die Verzögerungen durch Vorbereitungszyklen entfallen hier somit vollständig, abhängig vom entsprechenden SDRAM-Typ und den mit ihm verbundenen Zeitverzögerungen.

Die Erfindung ist nicht auf die beschriebenen Beispiele beschränkt. Grundsätzlich kann jeder Burst-Zugriff auch auf mehr als zwei Teil-Burst-Zugriffe aufgespalten werden, und die unterschiedlichen physikalischen Zugriffsadressen der verschiedenen Speicherbänke im physikalischen Adressraum müssen auch nicht notwendigerweise aneinander anschließen. Grundsätzlich können die Teil-Burst-Zugriffe auch eine unterschiedliche Länge aufweisen; einfacher ist jedoch eine Implementierung mit Teil-Burst-Zugriffen gleicher Länge. Die Erfindung ist auch nicht auf bestimmte Typen von SDRAMs beschränkt, sondern für beliebige SDRAMs mit mindestens 2 Speicherbänken anwendbar, da, wie in Figur 3 gezeigt wurde, hinsichtlich der Ein- und Ausgangssignale der Steuereinrichtung keine Veränderung zu bestehenden Steuereinrichtungen vorgenommen wurde. Die wesentlichen Elemente der Steuereinrichtung zur Durchführung des erfindungsgemäßen Verfahrens könnten im übrigen auch in die das SDRAM (3 in Figur 1) umgebene Speichereinheit (2 in Figur 1) integriert sein.

**Patentansprüche**

1. Steuereinrichtung (10) zur Steuerung von Burst-Zugriffen auf eine synchrone dynamische, wenigstens zwei Speicherbänke aufweisende Halbleiterspeichervorrichtung (3) mit einer Adresswandlereinheit (12) zur Umwandlung einer logischen Zugriffsadresse in physikalische Zugriffsadressen durch Aufspaltung des Burst-Zugriffs in wenigstens zwei Teil-Burst-Zugriffe, wobei eine erste physikalische Zugriffsadresse einen ersten Speicherbereich einer ersten Speicherbank für einen ersten Teil-Burst-Zugriff adressiert und wobei eine zweite physikalische Zugriffsadresse einen zweiten Speicherbereich einer zweiten Speicherbank für einen zweiten Teil-Burst-Zugriff adressiert, und der erste Teil-Burst-Zugriff und der zweite Teil-Burst-Zugriff werden nacheinander ausgeführt, wobei der zweite Teil-Burst-Zugriff wird während der Durchführung des ersten Teil-Burst-Zugriff vorbereitet.

2. Steuereinrichtung nach Anspruch 1,
**dadurch gekennzeichnet,**

**dass** die Steuereinrichtung (10) derart ausgestaltet ist, dass die Spaltenadressen der ersten und zweiten physikalischen Zugriffsadressen aneinander anschliessen.

3. Steuereinrichtung nach Anspruch 1,
**dadurch gekennzeichnet,**
**dass** die Steuereinrichtung (10) derart ausgestaltet ist, dass während eines Teil-Burst-Zugriffs auf den durch die erste physikalische Zugriffsadresse adressierten Speicherbereich einer ersten Speicherbank ein anderer Teil-Burst-Zugriff auf einen durch eine weitere physikalische Zugriffsadresse adressierten Speicherbereich einer anderen Speicherbank vorbereitet wird.

4. Steuereinrichtung nach Anspruch 1,
**dadurch gekennzeichnet,**
**dass** die Adresswandlereinheit (12) derart ausgestaltet ist, dass ein Burst-Zugriff der Länge N auf eine logische Zugriffsadresse A einer Speicherbank X aufgeteilt wird in einen ersten Teil-Burst-Zugriff der Länge N/2 auf eine erste physikalische Zugriffsadresse B, vorzugsweise die Zugriffsadresse A, einer ersten Speicherbank Y, vorzugsweise die Speicherbank X, und einen zweiten Teil-Burst-Zugriff der Länge N/2 auf eine zweite physikalische Zugriffsadresse C, vorzugsweise die Zugriffsadresse A+N/2 einer zweiten Speicherbank Y+Z, vorzugsweise die Speicherbank X+Z, wobei Z eine ganze Zahl ungleich Null ist, vorzugsweise +1, wenn Y eine gerade ganze Zahl ist, oder-1, wenn Y eine ungerade ganze Zahl ist.

5. Steuereinrichtung nach Anspruch 1,
**dadurch gekennzeichnet,**
**dass** die Adresswandlereinheit (12) derart ausgestaltet ist, dass ein Burst-Zugriff der Länge N auf eine logische Zugriffsadresse A einer Speicherbank X aufgeteilt wird in einen ersten Teil-Burst-Zugriff der Länge N/2 auf eine erste physikalische Zugriffsadresse B einer ersten Speicherbank Y und einen zweiten Teil-Burst-Zugriff der Länge N/2 auf eine zweite physikalische Zugriffsadresse B einer zweiten Speicherbank Y+Z, wobei Z eine ganze Zahl ungleich Null ist und wobei vorzugsweise A gleich B ist.

6. Steuereinrichtung nach Anspruch 5,
**dadurch gekennzeichnet,**
**dass** die Adresswandlereinheit (12) zur Umwandlung der logischen Zugriffsadressen in physikalische Zugriffsadressen durch Hinzufügen wenigstens eines Bits zur Bestimmung der Speicherbank ausgestaltet ist.

7. Verfahren zur Steuerung von Burst-Zugriffen auf eine synchrone dynamische, wenigstens zwei Speicherbänke aufweisende Halbleiterspeichervorrichtung (3), wobei eine logische Zugriffsadresse in physikalische Zugriffsadressen durch Aufspaltung des Burst-Zugriffs in wenigstens zwei Teil-Burst-Zugriffe umgewandelt wird, wobei eine erste physikalische Zugriffsadresse einen ersten Speicherbereich einer ersten Speicherbank für einen ersten Teil-Burst-Zugriff adressiert und wobei eine zweite physikalische Zugriffsadresse einen zweiten Speicherbereich einer zweiten Speicherbank für einen zweiten Teil-Burst-Zugriff adressiert, und der erste Teil-Burst-Zugriff und der zweite Teil-Burst-Zugriff werden nacheinander ausgeführt, wobei der zweite Teil-Burst-Zugriff wird während der Durchführung des ersten Teil-Burst-Zugriff vorbereitet.

8. Video-Speicheranordnung mit einer Steuereinrichtung nach einem der Ansprüche 1 bis 7, wobei die Halbleiterspeichervorrichtung (3) zum Speichern von Videodaten vorgesehen ist.

**Claims**

1. Control device (10) for controlling burst access operations on a synchronous dynamic semiconductor memory apparatus (3), having at least two memory banks, and having an address converter unit (12) for converting a logical access address into physical access addresses by splitting the burst access operation into at least two burst access suboperations, wherein a first physical access address addresses a first memory area in a first memory bank for a first burst access suboperation, and wherein a second physical access address addresses a second memory area in a second memory bank for a second burst access suboperation, and the first burst access suboperation and the second burst access suboperation are executed in succession, the second burst access suboperation being prepared during the performance of the first burst access suboperation.

2. Control device according to Claim 1,
**characterized**
**in that** the control device (10) is designed such that the column addresses of the first and second physical access addresses adjoin one another.

3. Control device according to Claim 1,
**characterized**
**in that** the control device (10) is designed such that, during a burst access suboperation on the memory area addressed by the first physical access address in a first memory bank, another burst access suboperation on a memory area addressed by a further physical access address in another memory bank is prepared.

4. Control device according to Claim 1,
**characterized**
**in that** the address converter unit (12) is designed such that a burst access operation of length N on a logical access address A in a memory bank X is split into a first burst access suboperation of length N/2 on a first physical access address B, preferably the access address A, in a first memory bank Y, preferably the memory bank X, and into a second burst access suboperation of length N/2 on a second physical access address C, preferably the access address A+N/2 in a second memory bank Y+Z, preferably the memory bank X+Z, Z being an integer not equal to zero, preferably +1 when Y is an even integer or -1 when Y is an uneven integer.

5. Control device according to Claim 1,
**characterized**
**in that** the address converter unit (12) is designed such that a burst access operation of length N on a logical access address A in a memory bank X is split into a first burst access suboperation of length N/2 on a first physical access address B in a first memory bank Y and into a second burst access suboperation of length N/2 on a second physical access address B in a second memory bank Y+Z, Z being an integer not equal to zero and preferably A being equal to B.

6. Control device according to Claim 5,
**characterized**
**in that** the address converter unit (12) is designed to convert the logical access addresses into physical access addresses by adding at least one bit for determining the memory bank.

7. Method for controlling burst access operations on a synchronous dynamic semiconductor memory apparatus (3), having at least two memory banks, wherein a logical access address is converted into physical access addresses by splitting the burst access operation into at least two burst access suboperations, wherein a first physical access address addresses a first memory area in a first memory bank for a first burst access suboperation, and wherein a second physical access address addresses a second memory area in a second memory bank for a second burst access suboperation, and the first burst access suboperation and the second burst access suboperation are executed in succession, the second burst access suboperation being prepared during the performance of the first burst access suboperation.

8. Video memory arrangement having a control device according to one of Claims 1 to 7, wherein the semiconductor memory apparatus (3) is provided for the purpose of storing video data.

## Revendications

1. Dispositif de commande (10) destiné à commander des salves d'accès à un ensemble (3) de mémoire semi-conductrice à dynamique synchrone et présentant au moins deux batteries de mémoire, le dispositif de commande présentant une unité (12) de conversion d'adresse qui convertit une adresse logique d'accès en adresse physique d'accès par division de la salve d'accès en au moins deux parties de salve d'accès, une première adresse physique d'accès adressant une première partie de mémoire d'une première batterie de mémoire pour une première salve partielle d'accès et une deuxième adresse physique d'accès adressant une deuxième partie de mémoire d'une deuxième batterie de mémoire pour une deuxième salve partielle d'accès, la première salve partielle d'accès et la deuxième salve partielle d'accès étant exécutées l'une après l'autre et la deuxième salve partielle d'accès étant préparée pendant l'exécution de la première salve d'accès.

2. Dispositif de commande selon la revendication 1, **caractérisé en ce que** le dispositif de commande (10) est configuré de manière à ce que les adresses de colonne de la première et de la deuxième adresse physique d'accès se raccordent l'une à l'autre.

3. Dispositif de commande selon la revendication 1, **caractérisé en ce que** le dispositif de commande (10) est configuré de manière à ce que pendant une salve partielle d'accès à la partie de mémoire d'une première batterie de mémoire adressée par la première adresse physique d'accès, une autre salve partielle d'accès à une autre partie de mémoire d'une autre batterie de mémoire adressée par une autre adresse physique d'accès soit préparée.

4. Dispositif de commande selon la revendication 1, **caractérisé en ce que** l'unité (12) de conversion d'adresse est configurée de telle sorte qu'une salve d'accès de longueur N à une adresse logique d'accès A d'une batterie de mémoire X soit divisée en une première salve partielle d'accès de longueur N/2 à une première adresse physique d'accès B, de préférence l'adresse d'accès A, d'une première batterie de mémoire Y, de préférence la batterie de mémoire X, et en une deuxième salve partielle d'accès de longueur N/2 à une deuxième adresse physique d'accès C, de préférence à l'adresse d'accès A+N/2 d'une deuxième batterie de mémoire Y+Z, de préférence de la batterie de mémoire X+Z, Z étant un nombre entier différent de zéro, de préférence +1 si Y est un nombre entier pair ou -1 si Y est un nombre entier impair.

5. Dispositif de commande selon la revendication 1, **caractérisé en ce que** l'unité (12) de conversion d'adresse est configurée de telle sorte qu'une salve d'accès de longueur N à une adresse logique d'accès A d'une batterie de mémoire X soit divisée en une première salve partielle d'accès de longueur N/2 à une première adresse physique d'accès B d'une première batterie de mémoire Y et en une deuxième salve partielle d'accès de longueur N/2 à une deuxième adresse physique d'accès B d'une deuxième batterie de mémoire Y+Z, Z étant un nombre entier différent de zéro et A étant de préférence égal à B.

6. Dispositif de commande selon la revendication 5, **caractérisé en ce que** l'unité (12) de conversion d'adresse est configurée pour convertir les adresses logiques d'accès en adresses physiques d'accès par addition d'au moins un bit qui définit la batterie de mémoire.

7. Procédé de commande de salves d'accès à un ensemble (3) de mémoire semi-conductrice à dynamique synchrone et présentant au moins deux batteries de mémoire, dans lequel une adresse logique d'accès est convertie en adresse physique d'accès par division de la salve d'accès en au moins deux salves partielles d'accès, une première adresse physique d'accès adressant une première partie de mémoire d'une première batterie de mémoire pour une première salve partielle d'accès et une deuxième adresse physique d'accès adressant une deuxième partie de mémoire d'une deuxième batterie de mémoire pour une deuxième salve partielle d'accès, la première salve partielle d'accès et la deuxième salve partielle d'accès étant exécutées l'une après l'autre, la deuxième salve partielle d'accès étant préparée pendant l'exécution de la première salve partielle d'accès.

8. Système de mémoire vidéo doté d'un dispositif de commande selon l'une des revendications 1 à 7, l'ensemble (3) de mémoire semi-conductrice étant prévu pour conserver en mémoire des données vidéo.

FIG.1

FIG.2

10

_CS
_RAS
_CAS
_WE

CS

W/R̄

11

_ADDR0-21

12

_ADDR0-11

_BA0-1

DW0-15

DR0-15

_DOUT0-15

_DIN0-15

FIG.3

FIG.4

FIG.5

| a 21 | a 20 | a 19 | a 18 | a 17 | a 16 | a 15 | a 14 | a 13 | a 12 | a 11 | a 10 | a9 | a8 | a7 | a6 | a5 | a4 | a3 | a2 | a1 | a0 |
|------|------|------|------|------|------|------|------|------|------|------|------|----|----|----|----|----|----|----|----|----|----|

6

| b1 | 0/1 |
|----|-----|

| r11 | r10 | r9 | r8 | r7 | r6 | r5 | r4 | r3 | r2 | r1 | r0 |
|-----|-----|----|----|----|----|----|----|----|----|----|----|

| c7 | c6 | c5 | c4 | c3 | c2 | c1 | c0 |
|----|----|----|----|----|----|----|----|

74  73

72

71   7

## FIG.6

FIG.7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5636173 A